# EUROPÄISCHE PATENTSCHRIFT

(11) **EP 0 525 281 B1**
(45) Veröffentlichungstag und Bekanntmachung des Hinweises auf die Patenterteilung: **21.09.1994**
(21) Anmeldenummer: 92102355.2
(22) Anmeldetag: 13.02.1992
(51) Int. Cl.: C23C 14/24, C23C 14/50

(54) **Vorrichtung zum Beschichten von Werkstückflächen**
Apparatus for coating workpiece surfaces
Dispositif pour revêtement des surfaces des pièces

(30) Priorität: 31.07.1991 DE 4125350
(43) Veröffentlichungstag der Anmeldung: 03.02.1993
(73) Patentinhaber: LEYBOLD AKTIENGESELLSCHAFT, D-63450 Hanau (DE)
(72) Erfinder: Schönherr, Bernhard, W-6050 Offenbach (DE); Vogt, Thomas, W-8756 Kahl (DE); Gertmann, Reiner, W-6464 Linsengericht 5 (DE); Grimm, Helmut, Dr., W-6100 Darmstadt (DE); Löbig, Gerard, W-6000 Frankfurt/M 90 (DE); Hornung, Martin, W-8751 Mömmlingen (DE)

(56) Entgegenhaltungen:
- EP-A- 0 084 126
- DE-A- 3 925 283
- FR-A- 2 551 091

## Beschreibung

Die Erfindung betrifft eine Vorrichtung zum Beschichten von Werkstückflächen, beispielsweise von Kondensatorfolien, mit einem zu verdampfenden Beschichtungsmaterial, insbesondere Reinaluminium, wobei das Beschichtungsmaterial in einem in einer Vakuumkammer angeordneten Verdampferschiffchen aufschmelzbar ist und in Gestalt eines Drahtabschnitts dem Verdampferschiffchen entsprechend der Schmelzbadhöhe von einer Drahtvorratsrolle aus zuführbar ist und zu diesem Zweck nach Art eines Capstan-Triebs zwischen einer motorisch angetriebenen Welle und einer den Gegendruck bewirkenden Rolle hindurchgeführt ist.

Es ist üblich bei Folienbedampfungsanlagen eine Vielzahl von Verdampferschiffchen zu einer sogenannten Verdampferbank zusammenzufassen und diese Verdampferbank in der Vakuumkammer in unmittelbarer Nähe der zu bedampfenden Folie anzuordnen und das zu verdampfende Material in Form von Drähten von Vorratsrollen abzuziehen und mit Hilfe von Reibradgetrieben zu transportieren und den Verdampferschiffchen zuzuführen.
(US 3.488.214, DOS 34 28 651, US 2.664.853, US 3.970.820)

Bekannt ist auch eine Vorrichtung der infragestehenden Art (FR-A-2.551.091) bei der dem Verdampfertiegel zugeführter Draht zwischen zwei gegenläufig angetriebenen Reibrädern hindurchgeführt ist, wobei die Reibräder unter Vorspannung am Draht anliegen und diesen durch einen Spalt bis in die Kavität des Verdampfertiegels fördern. Der Spalt wird dabei aus einer oberhalb des Verdampfertiegels angeordneten Blende und einem den Verdampfertiegel verlängernden Ansatz gebildet.

Eine besondere Schwierigkeit besteht nun erfahrungsgemäß darin, sicherzustellen, daß die Drahtzuführungsvorrichtungen aller nebeneinander angeordneter, die Verdampferbank bildenden Verdampferschiffchen in Abhängigkeit der Schmelzbadhöhe des jeweiligen Verdampferschiffchens gesteuert werden. Die hierzu notwendigen mechanischen und elektrotechnischen Einrichtungen sind im allgemeinen sehr aufwendig ausgebildet (siehe die Vorrichtung gemäß US 3.970.820), insbesondere weil die einzelnen Zuführungsvorrichtungen elektrisch gegeneinander isoliert sein müssen.

Besteht der Drahtverdampfer einer Bandbeschichtungsanlage aus mehreren, über eine gemeinsame Welle angetriebenen, Einzelverdampfern (siehe hierzu EP 0.084.126), so muß die den Draht zuführende gemeinsame Antriebswelle zwischen je zwei Zuführungsvorrichtungen elektrisch isoliert sein, was aus den unterschiedlichen elektrischen Spannungen, die an den einzelnen Verdampferschiffchen anliegen, resultiert. Man teilt deshalb im allgemeinen die Antriebswelle in mehrere Wellen-Abschnitte auf (und zwar entsprechend der Anzahl der auf der Verdampferbank vorgesehenen Verdampferschiffchen) und verbindet diese Wellen-Abschnitte durch Zwischenstücke aus einem isolierenden Material.

Der vorliegenden Erfindung liegt nun die Aufgabe zugrunde eine besonders einfach aufgebaute und damit preiswert herstellbare Drahtzuführungsvorrichtung für eine Verdampferbank zu schaffen, die dennoch eine individuelle und besonders feinfühlige Regelung des Drahtvorschubs gestattet.

Diese Aufgabe wird erfindungsgemäß dadurch gelöst, daß eine mit einem elektrisch isolierenden Überzug versehene, vorzugsweise aus eloxiertem Aluminium gefertigte einstückige Antriebswelle mit einer Gegenrolle zusammenwirkt, die auf einem beweglich gelagerten Hebel gelagert ist, der seinerseits über einem elektrischen Hubmagneten gegen die Kraft eines federnden Elements bewegbar ist, wodurch die zwischen dem Draht einerseits und der Antriebswelle andererseits wirksame Friktion veränderbar ist.

Bevorzugte Ausführungsformen sind in den abhängigen Ansprüchen 2 bis 4 offenbart.

Die Erfindung läßt die verschiedensten Ausführungsmöglichkeiten zu; eine davon ist in der anhängenden Zeichnung schematisch näher dargestellt, die die Vorrichtung zum Transport und zur Zuführung eines Drahtes zu einem zugeordneten Verdampferschiffchen in der Seitenansicht zeigt.

Die durchgehende, isolierte Antriebswelle aus eloxiertem Aluminium ist mit 1 bezeichnet. Mit 2 ist die Gegenrolle gekennzeichnet, die den notwendigen Anpreßdruck für den Transport des Drahtabschnitts 7 aufbringt. Dieser Anpreßdruck wird von einer Feder 3 erzeugt, die den Schwenkhebel 4 um seinen Drehpunkt bzw. den Zapfen 5 dreht.

Der auf dem Zapfen 5 gehaltene Schwenkhebel 4 wird von dem auf dem Montageträger 9 befestigten Hubmagneten 6 soweit in die Gegenrichtung gedreht, bis das Lüftspiel zwischen Antriebswelle 1 und Gegenrolle 2 den Transport des Drahtes 7 unmöglich macht. Der im Millisekundenbereich ansteuerbare Magnet 6 macht durch das Variieren der Einschaltzeiten eine kontinuierliche regelbare Drahtzuführungsgeschwindigkeit möglich.

Der Grundkörper 8, der der Lagerung der Antriebswelle und des Hebels 4 dient ist unter Zwischenlegen eines Isolators 13 mit dem Montageträger 9 verschraubt. Der Stößel 14 des Hubmagneten liegt am freien Ende des Schwenkhebels 4 an und kann in seiner Länge über eine Schraubhülse 15 verstellt werden. Der zwischen der Anruckrolle 2 und der einteiligen Antriebswelle 1 hindurchgeführte Drahtabschnitt 7 ist einerseits durch eine Hülse 16 und andererseits durch ein Rohrstück 17 geführt. Die Hülse 16 sind dazu am Schwenkhebel 4 und das Rohrstück 17 am Grundkörper 8 befestigt. Das Verdampferschiffchen 10 ist zwischen Backen 18,19 eingespannt, die sich ihrerseits am Montageträger 9 abstützen. Der Hubmagnet 6 wird - was nicht näher dargestellt ist - über ein Schaltgerät angesteuert und ist im übrigen gegenüber dem Montageträger 9 elektrisch isoliert an diesem befestigt.

Der Begriff "eloxieren" bzw. "Eloxalschicht" steht hier für die anodische Oxidation von Aluminiumwerkstoffen.

### Auflistung der Einzelteile

- 1: Elektrisch isolierende Antriebswelle
- 2: Gegenrolle, Andruckrolle
- 3: Feder, Federelement
- 4: Schwenkhebel, zweiarmiger Hebel
- 5: Drehpunkt, Zapfen
- 6: Hubmagnet
- 7: Draht, Aluminiumdraht
- 8: Grundkörper
- 9: Montageträger
- 10: Verdampferschiffchen
- 11: Zapfen
- 12: Lagerbohrung
- 13: Isolator, isolierende Zwischenplatte
- 14: Stößel
- 15: Schraubhülse
- 16: Hülse
- 17: Rohrstück
- 18: Einspannbacke
- 19: Einspannbacke

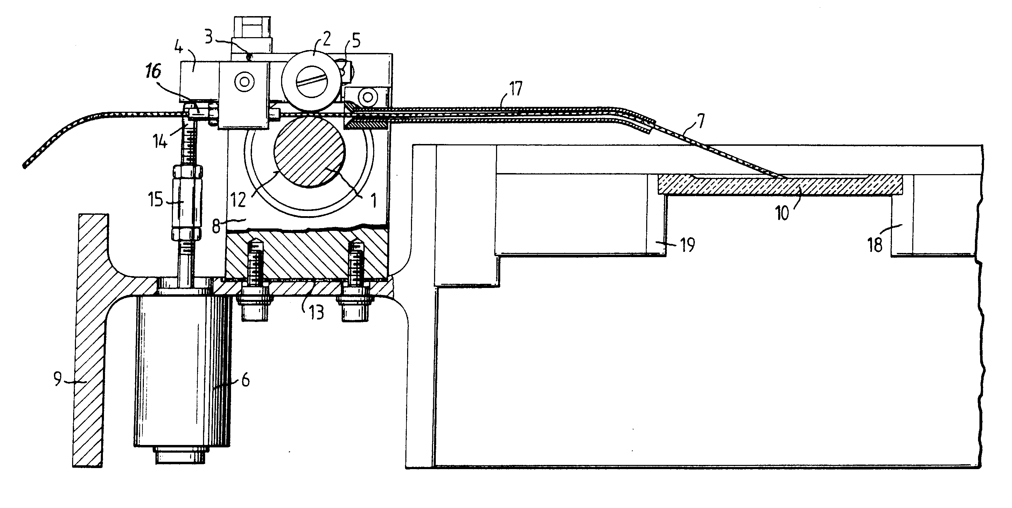

## Patentansprüche

1. Vorrichtung zum Beschichten von Werkstückflächen, beispielsweise von Kondensatorfolien mit einem zu verdampfenden Beschichtungsmaterial, vorzugsweise Reinaluminium, wozu das Beschichtungsmaterial in einem in einer Vakuumkammer angeordneten Verdampferschiffchen (10) aufschmelzbar ist und in Gestalt eines Drahtabschnitts (7) dem Verdampferschiffchen (10) entsprechend der Schmelzbadhöhe von einer Drahtvorratsrolle aus zuführbar ist und zu diesem Zweck nach Art eines Capstan- Triebs zwischen einer motorisch angetriebenen Welle (1) und einer den Gegendruck bewirkenden Rolle (2) hindurchgeführt ist, **dadurch gekennzeichnet**, daß eine mit einem elektrisch isolierenden Überzug versehene, einstükkige Antriebswelle (1) mit der Gegenrolle (2) zusammenwirkt, die auf einem beweglich gelagerten Hebel (4) gelagert ist, der seinerseits über einen Hubmagneten (6) gegen die Kraft eines federnden Elements (3) bewegbar ist, wodurch die zwischen dem Draht (7) einerseits und der Antriebswelle (1) andererseits wirksame Friktion veränderbar ist.

2. Vorrichtung nach Anspruch 1**, dadurch gekennzeichnet,** daß die einstückige Antriebswelle (1) mit einem eloxiertem (anodisch oxidiertem) Aluminium-Werkstoff versehen ist.

3. Vorrichtung nach Anspruch 1, **dadurch gekennzeichnet,** daß der Grundkörper (8) mit der Lagerbohrung (12) für die Antriebswelle (1) und mit dem Zapfen (5) für die Halterung des Schwenkhebels (4) mit Gegenrolle (2) über eine elektrisch isolierende Zwischenplatte (13) auf dem Montageträger (9) befestigt ist.

4. Vorrichtung nach den Ansprüchen 1 bis 3, **dadurch gekennzeichnet**, daß der Betätigungsstößerl (14) des Hubmagneten (6) etwa rechtwinklig zum Schwenkhebel (4) am Montageträger (9) angeordnet ist und in seiner Länge verstellbar ist, wobei der Hubmagnet (6) von einem Schaltgerät ansteuerbar ist, das in Abhängikeit der jeweils am zugeordneten Verdampferschiffchen (10) anliegenden Spannung arbeitet.

## Claims

1. Device for coating workpiece surfaces, for instance condenser foils, with a coating material to be vaporised, preferably pure aluminium, for which purpose the coating material is capable of being smelted in a vaporiser pan (10) arranged in a vacuum chamber and of being supplied to the vaporiser pan (10) from a wire supply reel in the form of a wire portion (7) in accordance with the height of the melting bath and for this purpose is guided in the manner of a capstan drive between a shaft (1) driven by a motor and a roller (2) bringing about the counterpressure, characterised in that a one-piece drive shaft (1) provided with an electrically insulating coating interacts with the counter-roller (2) which is supported on a moveably supported lever (4) which in turn is capable of being moved via a lifting magnet (6) against the force of a resilient element (3), as a result of which the effective friction between the wire (7) on the one hand and the drive shaft (1) on the other hand is capable of being varied.

2. Device according to Claim 1, characterised in that the one-piece drive shaft (1) is provided with an eloxated (anodically oxidised) aluminium material.

3. Device according to claim 1, characterised in that the basic unit (8) is attached to the bearing bore (12) for the drive shaft (1) and to the spigot (5) for retaining the pivoting lever (4) with counter-roller (2) via an electrically insulating intermediate plate (13) on the mounting support (9).

4. Device according to Claims 1 to 3, characterised in that the actuating tappet (14) of the lifting magnet (6) is arranged on the mounting support (9) so as to be approximately perpendicular to the pivoting lever (4) and is of adjustable length, whereby the lifting magnet (6) is capable of being controlled by a switchgear operating as a function of the voltage supplied at any given time to the vaporiser pan (10) assigned.

## Revendications

1. Dispositif pour revêtir des surfaces de pièces, par exemple des feuilles de condensateurs avec une matière de revêtement à évaporer, de préférence de l'aluminium pur, la matière de revêtement pouvant à cet effet être fondue dans un creuset d'évaporateur (10) disposé dans une chambre à vide, et être acheminée au creuset (10), sous la forme d'un segment de fil (7), en fonction de la profondeur du bain fondu, en partant d'une bobine de réserve de fil, et étant à cet effet placée entre un arbre (1) entraîné au moteur et un rouleau (2) gui applique une contre-pression, à la façon d'un entraînement par cabestan, caractérisé en ce gu'un arbre d'entraînement (1) en une seule pièce, muni d'un revêtement isolant de l'électricité, coopère avec le contre-rouleau (2), lequel tourillonne sur un levier oscillant (4) qui, de son côté, peut être mis en mouvement, au moyen d'un électro-aimant (6) à l'encontre de la force d'un élément élastique (3), ce qui permet de régler le frottement qui agit entre le fil (7), d'une part, et l'arbre d'entraînement (1), d'autre part.

2. Dispositif selon la revendication 1, caractérisé en ce que l'arbre d'entraînement (1) en une seule pièce est muni d'aluminium éloxydé (traité par oxydation anodique).

3. Dispositif selon la revendication 1, caractérisé en ce que le corps de base (8) qui présente le perçage de portée (12) de l'arbre d'entraînement (1), et le tourillon (5) de montage du levier oscillant (4) qui porte le contre-rouleau (2), est fixé sur le support de montage (9) avec interposition d'une plaque intermédiaire (13) isolante de l'électricité.

4. Dispositif selon les revendications 1 à 3, caractérisé en ce que le poussoir de manoeuvre (14) de l'électroaimant (6) est disposé à peu près perpendiculairement au levier oscillant (4) sur le support de montage (9), et est réglable en longueur, l'électro-aimant (6) pouvant être piloté par un appareil de commutation qui travaille en fonction de la tension appliquée au creuset (10) qui lui est associé.
